# EUROPEAN PATENT APPLICATION

(11) **EP 3 537 476 A1**
(43) Date of publication of application: **11.09.2019**
(21) Application number: 17871770.8
(22) Date of filing: 20.06.2017
(51) Int. Cl.: H01L 21/60, H01L 21/56, H01L 25/10, H01L 21/98

(54) **CHIP PACKAGING STRUCTURE AND METHOD**

(30) Priority: 18.11.2016 CN 201611028571
(71) Applicant: Huawei Technologies Co., Ltd., Longgang District Shenzhen, Guangdong 518129 (CN)
(72) Inventor: FU, Huili, Shenzhen Guangdong 518129 (CN); LI, Heng, Shenzhen Guangdong 518129 (CN); ZHANG, Xiaodong, Shenzhen Guangdong 518129 (CN)
(74) Representative: Goddar, Heinz J.
(86) International application number: PCT/CN2017/089188
(87) International publication number: WO 2018/090622

(57) **Abstract**

Embodiments of this application disclose a chip package structure and packaging method, so as to reduce a package structure thickness, increase pin density, increase a quantity of interconnection channels, and increase bandwidth of a top-layer chip. The chip package structure includes: a redistribution layer RDL; a target chip, including an active surface and a back surface, where the active surface of the target chip is connected to a first surface of the RDL; a substrate, where a first surface of the substrate is opposite to the back surface of the target chip; and an interconnection channel, located around the target chip, where one end of the interconnection channel is connected to the first surface of the RDL, and the other end of the interconnection channel is connected to the first surface of the substrate.

## Description

This application claims priority to Chinese Patent Application No. 201611028571.1, filed with the Chinese Patent Office on November 18, 2016 and entitled "CHIP PACKAGE STRUCTURE AND PACKAGING METHOD", which is incorporated herein by reference in its entirety.

### TECHNICAL FIELD

This application relates to the field of chip package, and more specifically, to a chip package structure and packaging method.

### BACKGROUND

With a rapid increase of portable electronic products, a semiconductor package structure installed on a printed circuit board (Printed Circuit Broad, PCB) in an electronic device is gradually smaller and thinner. Therefore, package becomes more important in an industry chain.

Currently, in a known package structure, a chip is packaged between an upper-layer substrate and a lower-layer substrate by using a package on package (Package on Package, POP) technology. Specifically, the lower-layer substrate may be used to carry a target chip, and the upper-layer substrate may be used to carry a top-layer chip. Multiple layers of chip package structures may be stacked in a vertical direction by using a support function of the upper-layer substrate and the lower-layer substrate, so that three-dimensional package is implemented. The upper-layer substrate may be an interposer (interposer) substrate, and the lower-layer substrate may be a common organic substrate. A molding compound (Molding Compound, MC) may be filled between the chip and the substrate, and the MC has a vertical interconnect system (Vertical Interconnects System, VIS), so as to implement an electrical interconnection between the upper-layer substrate and the lower-layer substrate.

However, packaging the chip by using two layers of substrates causes a thickness of the entire package structure (including the upper-layer substrate, the MC, the target chip, and the lower-layer substrate) to be relatively large (for example, to be approximately 490 micrometers (µm)). Consequently, this cannot meet a requirement for a smaller and thinner semiconductor package structure in a current technology, and is not beneficial to heat dissipation of the chip.

Therefore, a technology needs to be provided to reduce the thickness of the package structure.

### SUMMARY

This application provides a chip package structure and packaging method, to replace a lower-layer substrate with a redistribution layer (Redistribution Layer, RDL), so that a package structure thickness is reduced, pin density is increased, interconnection channel density is increased, and bandwidth of a top-layer chip is increased.

According to a first aspect, a chip package structure is provided, including:
a redistribution layer RDL;
a target chip, including an active surface and a back surface, where the active surface of the target chip is connected to a first surface of the RDL;
a substrate, where a first surface of the substrate is opposite to the back surface of the target chip; and
an interconnection channel, located around the target chip, where one end of the interconnection channel is connected to the first surface of the RDL, and the other end of the interconnection channel is connected to the first surface of the substrate.

Therefore, in the chip package structure in this embodiment of this application, a lower-layer substrate is replaced with the RDL, and compared with the prior art, a limitation on the package structure that is caused by a substrate processing technology is reduced.

Specifically, in the substrate processing technology (that is, a substrate-level technology), a size (for example, a thickness) of a substrate is relatively large, and a thickness of the entire chip package structure is limited by the substrate processing thickness. Therefore, the chip package structure is inapplicable to a product that has a relatively high thickness requirement. However, in this embodiment of this application, the RDL is prepared by using a wafer-level technology, and a thickness of the RDL can be well controlled, so that the total thickness is reduced, and the chip package structure can be more widely applied to a terminal device that has a relatively high thickness requirement. In addition, in the substrate processing technology, a distance between pins for connecting the chip is relatively large, that is, pin density is relatively small, and if a pin needs to be added, an area (or a package area) of the target chip needs to be increased. However, in this embodiment of this application, the RDL is prepared by using the wafer-level technology, and the distance between pins can be smaller, so that the pin density is increased.

Further, a thermal compression weld ball is used in an interconnection channel in the prior art, and when a height of the thermal compression weld ball is reduced at a high temperature, the weld ball is horizontally expanded. Therefore, a minimum distance between VIS channels is limited, and a quantity of VIS channels is limited, thereby limiting bandwidth of a top-layer chip. However, in this embodiment of this application, a copper pillar, a grinding weld ball, and the like are used to replace the thermal compression weld ball, so that a minimum distance between interconnection channels is prevented from being limited, interconnection channel density can be increased, and the bandwidth of the top-layer chip is further increased.

Still further, an upper-layer substrate is still retained in the chip package structure, so that a warping degree of the chip package structure can be well controlled to be within an acceptable range.

With reference to the first aspect, in a first possible implementation of the first aspect, the interconnection channel includes a first copper pillar that is implanted on the first surface of the substrate in advance.

With reference to the first aspect, in a second possible implementation of the first aspect, the interconnection channel includes a grinding weld ball and a first connector, one end of the grinding weld ball is connected to the RDL, and the other end of the grinding weld ball is connected to the first surface of the substrate by using the first connector; and
the grinding weld ball includes a solder ball, and the first connector includes any one of the following: a second copper pillar, pre-solder paste, or a weld ball.

With reference to the first aspect, in a third possible implementation of the first aspect, the interconnection channel includes a first copper pillar and a first connector, one end of the first copper pillar is connected to the RDL, and the other end of the first copper pillar is connected to the first surface of the substrate by using the first connector; and
the first connector includes pre-solder paste or a weld ball.

Therefore, the thickness can be further reduced by replacing the thermal compression weld ball with the described vertical interconnection channel to implement an electrical interconnection.

With reference to the first aspect or the foregoing possible implementations of the first aspect, in a fourth possible implementation of the first aspect, the RDL includes a metal wiring, the active surface of the target chip includes a pad, and the pad is connected to the metal wiring that is exposed on the first surface of the RDL.

Optionally, the chip package structure further includes a second connector, one end of the second connector is connected to the pad, and the other end of the second connector is connected to the metal wiring that is exposed on the first surface of the RDL.

Therefore, stress damage caused by grinding can be reduced by means of connection between the second connector and the first surface of the RDL.

With reference to the first aspect or the foregoing possible implementations of the first aspect, in a fifth possible implementation of the first aspect, the chip package structure further includes a molding compound MC, the MC is filled between the RDL and the substrate, and surrounds the target chip around the target chip, the interconnection channel extends through the MC in a first direction, and the first direction is basically vertical to the first surface of the RDL; where
the MC is a grindable material. That is, the MC has a characteristic of being capable of being ground, and a thickness of the MC may be reduced by means of grinding, so that the total thickness of the chip package structure is further reduced.

Herein, that the first direction is basically vertical to the first surface of the RDL may mean that an included angle between the first direction and the first surface of the RDL is approximately 90 degrees. That is, the included angle between the first direction and the first surface of the RDL may have a specific error range during preparation, but this may be ignored or is allowed.

It should be understood that the shown case herein in which the interconnection channel extends through the MC in the first direction is merely a possible implementation, and shall not constitute any limitation on this application. In an actual preparation process, the included angle between the first direction and the RDL may be approximately 90 degrees, or may be a specific inclination angle (for example, less than 90 degrees), and a case shall fall within the protection scope of this application as long as it is ensured that the interconnection channel can extend through a first surface and a second surface of the MC.

With reference to the first aspect or the foregoing possible implementations of the first aspect, in a sixth possible implementation of the first aspect, an adhesive material is coated between the first surface of the substrate and the back surface of the target chip, and the adhesive material includes at least one of the following: thermal compression non-conductive paste, a thermal compression non-conductive film, a die attach film, or epoxy.

The adhesive material may be coated between the back surface of the target chip and the first surface of the substrate, or may be coated on the edge of the target chip and between the first surface of the MC and the first surface of the substrate, to wrap the interconnection channel, so that the back surface of the target chip is protected, and reliability of the interconnection channel is improved.

According to a second aspect, a three-dimensional chip package structure is provided, including the chip package structure according to any one of the first aspect or the possible implementations of the first aspect.

Therefore, in the three-dimensional chip package structure in this embodiment of this application, a total thickness of the three-dimensional chip package structure can be reduced by using the chip package structure in the embodiments of this application.

It should be noted that the three-dimensional chip package structure in this embodiment of this application is not limited to using the chip package structure in the embodiments of this application, and the chip package structure in the embodiments of this application and a chip package structure in another form may be stacked together to obtain the three-dimensional chip package structure.

According to a third aspect, a chip packaging method is provided, including:
connecting an interconnection channel to a first surface of a substrate, where one end of the interconnection channel is connected to the first surface of the substrate;
connecting a target chip to the first surface of the substrate, where a back surface of the target chip is opposite to the first surface of the substrate; and
preparing a redistribution layer RDL, where the RDL is connected to the other end of the interconnection channel, and a first surface of the RDL is connected to an active surface of the target chip.

Therefore, in the chip package structure in this embodiment of this application, a lower-layer substrate is replaced with the RDL, and a limitation on the package structure that is caused by a substrate technology is reduced. A total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth of a top-layer chip is increased. In addition, an upper-layer substrate is still retained in the chip package structure, so that a warping degree of the chip package structure can be well controlled to be within an acceptable range.

With reference to the third aspect, in a first possible implementation of the third aspect, the interconnection channel includes a first copper pillar; and
the connecting an interconnection channel to a first surface of a substrate includes:
electroplating the first copper pillar on the first surface of the substrate.

Therefore, the thickness can be further reduced by replacing a thermal compression weld ball with the first copper pillar to implement an electrical interconnection.

With reference to the third aspect or the foregoing possible implementation of the third aspect, in a second possible implementation of the third aspect, before the preparing an RDL, the chip packaging method further includes:
filling the first surface of the substrate with a molding compound MC, so that the MC surrounds the target chip around the target chip; where
the active surface of the target chip includes a pad, the pad is preconnected to one end of a second connector, the other end of the second connector is exposed on a first surface of the MC, the interconnection channel extends through the MC in a first direction, and the first direction is basically vertical to the first surface of the RDL.

Therefore, the total thickness of the chip package structure can be further reduced by grinding the MC.

Herein, that the first direction is basically vertical to the first surface of the RDL may mean that an included angle between the first direction and the first surface of the RDL is approximately 90 degrees. That is, the included angle between the first direction and the first surface of the RDL may have a specific error range during preparation, but this may be ignored or is allowed.

It should be understood that the shown case herein in which the interconnection channel extends through the MC in the first direction is merely a possible implementation, and shall not constitute any limitation on this application. In an actual preparation process, the included angle between the first direction and the RDL may be approximately 90 degrees, or may be a specific inclination angle (for example, less than 90 degrees), and a case shall fall within the protection scope of this application as long as it is ensured that the interconnection channel can extend through the first surface and a second surface of the MC.

Optionally, the chip packaging method further includes:
grinding the first surface of the MC according to a preset thickness of the chip package structure.

With reference to the third aspect or the foregoing possible implementations of the third aspect, in a third possible implementation of the third aspect, the RDL includes a metal wiring, the active surface of the target chip includes the pad, the pad is preconnected to the one end of the second connector, and the chip packaging method further includes:
connecting the other end of the second connector to the metal wiring that is exposed on the first surface of the RDL, so that the metal wiring is connected to the active surface of the target chip.

Therefore, stress damage caused by grinding can be reduced by means of connection between the second connector and the first surface of the RDL.

According to a fourth aspect, a chip packaging method is provided, including:
preparing a redistribution layer RDL;
connecting an interconnection channel to a first surface of the RDL, where one end of the interconnection channel is connected to the first surface of the RDL;
connecting a target chip to the first surface of the RDL, where an active surface of the target chip is connected to the first surface of the RDL; and
placing a substrate on a back surface of the target chip, where a first surface of the substrate is connected to the other end of the interconnection channel.

Therefore, in the chip package structure in this embodiment of this application, a lower-layer substrate is replaced with the RDL, and a limitation on the package structure that is caused by a substrate technology is reduced. A total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth of a top-layer chip is increased. In addition, an upper-layer substrate is still retained in the chip package structure, so that a warping degree of the chip package structure can be well controlled to be within an acceptable range.

With reference to the fourth aspect, in a first possible implementation of the fourth aspect, the interconnection channel includes a grinding weld ball and a first connector, the grinding weld ball includes a solder ball, and the first connector includes a second copper pillar, pre-solder paste, or a weld ball;
the connecting an interconnection channel to a first surface of the RDL includes:
connecting to the first surface of the RDL by using one end of the grinding weld ball; and
connecting to one end of the first connector by using the other end of the grinding weld ball; and
the chip packaging method further includes:
   connecting, by using the first connector, to the first surface of the substrate by using the other end of the grinding weld ball.

With reference to the fourth aspect, in a second possible implementation of the fourth aspect, the interconnection channel includes a first copper pillar and a first connector, and the first connector includes pre-solder paste or a weld ball;
the connecting an interconnection channel to a first surface of the RDL includes:
connecting to the first surface of the RDL by using one end of the first copper pillar; and
connecting to one end of the first connector by using the other end of the first copper pillar; and
the chip packaging method further includes:
   connecting to the first surface of the substrate by using the other end of the first connector.

Therefore, the thickness can be further reduced by replacing a thermal compression weld ball with the described vertical interconnection channel to implement an electrical interconnection.

With reference to the fourth aspect or the foregoing possible implementations of the fourth aspect, in a third possible implementation of the fourth aspect, the RDL includes a metal wiring, the active surface of the target chip includes a pad, the pad is preconnected to one end of a second connector, and the chip packaging method further includes:
connecting the other end of the second connector to the metal wiring that is exposed on the first surface of the RDL, so that the metal wiring is connected to the active surface of the target chip.

Therefore, stress damage caused by grinding can be reduced by means of connection between the second connector and the first surface of the RDL.

With reference to the fourth aspect or the foregoing possible implementations of the fourth aspect, in a fourth possible implementation of the fourth aspect, before the placing a substrate on a back surface of the target chip, the chip packaging method further includes:
filling the first surface of the RDL with a molding compound MC, so that the MC surrounds the target chip around the target chip, where the back surface of the target chip is exposed on a second surface of the MC, the interconnection channel extends through the MC in a first direction, and the first direction is basically vertical to the first surface of the RDL.

Therefore, the total thickness of the chip package structure can be further reduced by grinding the MC.

Optionally, the chip packaging method further includes:
grinding the second surface of the MC according to a preset thickness of the chip package structure.

According to a fifth aspect, a chip packaging method is provided, including:
connecting an interconnection channel to a first surface of a first carrier;
connecting a target chip to the first surface of the first carrier, where an active surface of the target chip is at least partly in contact with the first surface of the first carrier;
placing a substrate on a back surface of the target chip, where a first surface of the substrate is connected to one end of the interconnection channel, and the back surface of the target chip is a surface that is of the target chip and that is parallel to the active surface;
removing the first carrier to expose the active surface of the target chip; and
preparing a redistribution layer RDL on the active surface of the target chip, where a first surface of the RDL is connected to the other end of the interconnection channel, and the first surface of the RDL is at least partly in contact with the active surface of the target chip.

Therefore, in the chip package structure in this embodiment of this application, a lower-layer substrate is replaced with the RDL, and a limitation on the package structure that is caused by a substrate technology is reduced. A total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth of a top-layer chip is increased. In addition, an upper-layer substrate is still retained in the chip package structure, so that a warping degree of the chip package structure can be well controlled to be within an acceptable range.

With reference to the fifth aspect, in a first possible implementation of the fifth aspect, the interconnection channel includes a grinding weld ball and a first connector, the grinding weld ball includes a solder ball, the first connector includes a second copper pillar, pre-solder paste, or a weld ball, and the chip packaging method further includes:
connecting to the first surface of the substrate by using one end of the first connector;
connecting to one end of the grinding weld ball by using the other end of the first connector; and
connecting to the first surface of the RDL by using the other end of the grinding weld ball.

With reference to the fifth aspect, in a second possible implementation of the fifth aspect, the interconnection channel includes a first copper pillar and a first connector, the first connector includes pre-solder paste or a weld ball, and the chip packaging method further includes:
connecting to the first surface of the substrate by using one end of the first connector;
connecting to one end of the first copper pillar by using the other end of the first connector; and
connecting to the first surface of the RDL by using the other end of the first copper pillar.

Therefore, the thickness can be further reduced by replacing a thermal compression weld ball with the described vertical interconnection channel to implement an electrical interconnection.

With reference to the fifth aspect or the foregoing possible implementations of the fifth aspect, in a third possible implementation of the fifth aspect, the RDL includes a metal wiring, the active surface of the target chip includes a pad, and the chip packaging method further includes:
soldering the pad onto the metal wiring that is exposed on the first surface of the RDL, so that the metal wiring is connected to the active surface of the target chip.

Therefore, in the chip packaging method in this embodiment of this application, the pad of the substrate may be directly connected to the surface of the RDL without a need to use a connector, so that fewer connectors are used, and a technology is simplified.

With reference to the fifth aspect or the foregoing possible implementations of the fifth aspect, in a fourth possible implementation of the fifth aspect, before the placing a substrate on a back surface of the target chip, the chip packaging method further includes:
filling the first surface of the carrier with a molding compound MC, so that the MC surrounds the target chip and the back surface of the target chip around the target chip, where the interconnection channel extends through the MC in a first direction, and the first direction is vertical to the first surface of the RDL.

Optionally, the chip packaging method further includes:
grinding a first surface of the MC according to a preset thickness of the chip package structure, where the first surface of the MC is opposite to the first surface of the substrate.

In some foregoing possible implementations, in an embodiment, a diameter of the first copper pillar is greater than or equal to 100 micrometers µm, and a height is greater than or equal to 100 µm.

In some foregoing possible implementations, in an embodiment, a diameter of the second copper pillar is less than 100 µm, a height of the second copper pillar is less than 100 µm, and a diameter of the weld ball is greater than 40 µm.

In some foregoing possible implementations, in an embodiment, a diameter of the weld ball is greater than 40 µm, a diameter of the first copper pillar is greater than or equal to 100 micrometers µm, and a height is greater than or equal to 100 µm.

In the chip package structure and packaging method in the embodiments of this application, the lower-layer substrate is replaced with the redistribution layer, so that the package structure thickness is reduced, the pin density is increased, the interconnection channel density is increased, and the bandwidth of the top-layer chip is increased.

### BRIEF DESCRIPTION OF DRAWINGS

FIG. 1 is a schematic diagram of a scenario that is applicable to a chip package structure according to an embodiment of this application;
FIG. 2 is a schematic structural diagram of a chip package structure according to an embodiment of this application;
FIG. 3 and FIG. 4 are schematic diagrams of connecting an interconnection channel to a substrate by using a first connector;
FIG. 5 is a schematic structural diagram of a chip package structure according to an embodiment of this application;
FIG. 6 to FIG. 12 are schematic diagrams of packaging a chip package structure in an embodiment of this application by using a chip packaging method;
FIG. 13 is a schematic structural diagram of a chip package structure according to another embodiment of this application;
FIG. 14 to FIG. 25 are schematic diagrams of packaging a chip package structure in another embodiment of this application by using another chip packaging method;
FIG. 26 is a schematic structural diagram of a chip package structure according to still another embodiment of this application;
FIG. 27 to FIG. 30 are schematic diagrams of packaging a chip package structure in still another embodiment of this application by using still another chip packaging method;
FIG. 31 is a schematic structural diagram of a chip package structure according to yet another embodiment of this application;
FIG. 32 is a schematic structural diagram of a three-dimensional chip package structure according to an embodiment of this application;
FIG. 33 is a schematic flowchart of a chip packaging method according to an embodiment of this application;
FIG. 34 is a schematic flowchart of a chip packaging method according to another embodiment of this application; and
FIG. 35 is a schematic flowchart of a chip packaging method according to still another embodiment of this application.

### DESCRIPTION OF EMBODIMENTS

The following clearly describes the technical solutions in the embodiments of this application with reference to the accompanying drawings in the embodiments of this application.

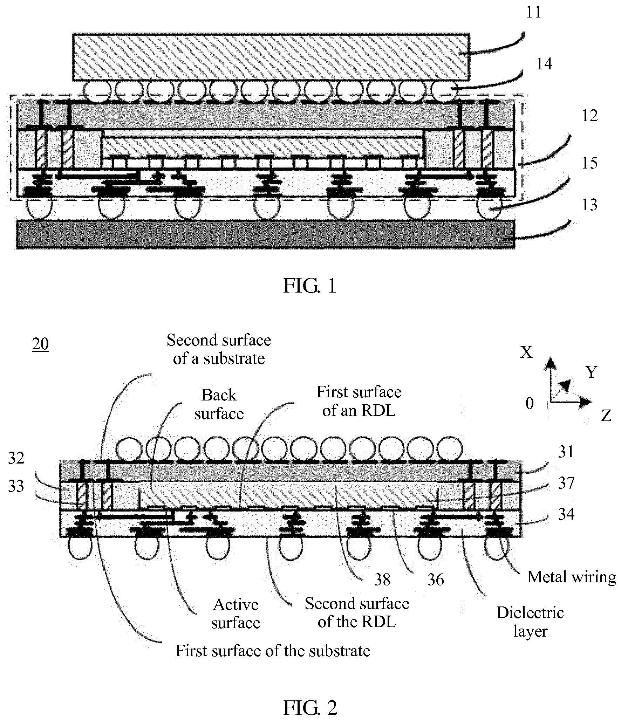

For ease of understanding, first, a scenario that is applicable to a chip package structure in the embodiments of this application is simply described with reference to FIG. 1.

FIG. 1 is a schematic diagram of a scenario that is applicable to a chip package structure according to an embodiment of this application. As shown in FIG. 1, the chip package structure 12 may be connected to a top-layer chip 11 by using a connector 14 (for example, a weld ball, which may be specifically a solder ball (solder ball) or the like), and the chip package structure 12 may be connected to a lower-layer printed circuit board (Printed Circuit Board, PCB) 13 by using a connector 15 (for example, a weld ball, which may be specifically a solder ball or the like). The top-layer chip 11 may be a structure or a package body such as a memory (Memory), an integrated passive device (Integrated Passive Devices, IPD), a micro-electro-mechanical system (Micro-Electro-Mechanical System, MEMS), or an interposer (interposer). It should be understood that the top-layer chip described herein is merely an example for description, and is not limited in this application.

The chip package structure in the embodiments of this application is described below in detail with reference to FIG. 2 to FIG. 32.

It should be understood that heights, diameters, or thicknesses of various mechanical parts shown below in the embodiments of this application and a total thickness of the chip package structure are merely examples for description. Example thicknesses are compared to reflect an effect of reducing a total thickness by using the chip package structure in the embodiments of this application, and this shall not constitute any limitation on this application. A case shall fall within the protection scope of this application as long as an RDL is used to replace one of two layers of substrates to perform chip packaging.

FIG. 2 is a schematic structural diagram of a chip package structure 20 according to an embodiment of this application. As shown in FIG. 2, the chip package structure 20 includes a substrate 31, a target chip 37, an interconnection channel 33, and a redistribution layer RDL 34.

It should be noted that FIG. 2 shows connectors (that may be corresponding to the connector 14 and the connector 15 in FIG. 1) merely for ease of understanding of a connection relationship between the chip package structure 20 and the outside. However, this shall not constitute any limitation on this application, and this application should not be limited thereto.

It should be further noted that, an aluminum pad (Aluminum Pad, AP, hereinafter referred to as a pad, as shown in FIG. 2) 36 is prepared on a surface of the target chip before the target chip is delivered (that is, before the target chip enters a packaging factory). The pad is used to fasten the target chip on another structure (for example, the RDL shown in this embodiment of this application) during packaging, and is electrically conductive. The target chip may include an active surface (that is, a surface on which the AP is prepared) and a back surface.

Generally, the active surface is basically parallel to the back surface. Herein, that the active surface is basically parallel to the back surface may mean that an included angle between the active surface and the back surface is approximately 0 degrees. That is, the included angle between the active surface and the back surface may have a specific error range during preparation, but this may be ignored or is allowed.

A person skilled in the art may understand that the active surface may be understood as a component (or a circuit) that can implement an expected function only when a power supply is included in the active surface. Passive is opposite to active, that is, a passive surface does not need a power supply to supply power. In this embodiment of this application, the AP is prepared on the active surface of the target chip, and is used to implement an electrical connection to the outside (specifically, a metal wiring in the RDL).

In this embodiment of this application, for ease of description, a surface that is opposite to the active surface of the target chip is denoted as a first surface of the RDL, and a surface that is opposite to the back surface of the target chip is denoted as a first surface of the substrate. The active surface of the target chip is connected to the first surface of the RDL. The interconnection channel is located around the target chip, one end is directly or indirectly connected to the first surface of the RDL, and the other end is directly or indirectly connected to the first surface of the substrate, so that an electrical interconnection between the RDL and the substrate is implemented. It should be noted that a quantity of interconnection channels is not particularly limited in this application.

Specifically, the RDL may include a dielectric layer and the metal wiring, and there may be one or more layers of metal wirings that are distributed in the dielectric layer, exposed on a first surface and a second surface of the dielectric layer, and shown by a solid black line in FIG. 2. It should be noted that a quantity of layers of metal wirings is not particularly limited in this application, and a metal wiring shall fall within the protection scope of this application as long as the metal wiring can be exposed on the first surface and the second surface of the dielectric layer to implement a connection to an external conductive structure. It may be understood that the first surface of the RDL and the first surface of the dielectric layer are on a same plane, and a second surface of the RDL and the second surface of the dielectric layer are on a same plane. That is, being exposed on the first surface of the dielectric layer may mean being exposed on the first surface of the RDL. For brevity, descriptions of same or similar cases are omitted below.

The target chip may be located above the first surface of the RDL, and is in contact, directly or by using a connector (for example, a connector 35 described below), with the metal wiring that is exposed on the first surface of the RDL. A case in which the target chip is in contact with the metal wiring in the RDL by using the connector is not shown in FIG. 2, and is described below in detail with reference to other embodiments (for example, a packaging method 1 and a packaging method 2).

As shown in FIG. 2, the active surface of the target chip includes the pad 36, and the pad may be understood as a pin for connecting the target chip to the outside. At least some pins of the target chip may be connected to the metal wiring that is exposed on the first surface of the RDL, or some pins of the target chip may be led out to a periphery of the chip by using a fan out wafer level package (Fan Out Wafer Level Package, FOWLP) technology, and connected to the metal wiring that is exposed on the first surface of the RDL. In other words, a point of contact between the target chip and the RDL may be the metal wiring on the first surface of the RDL.

A person skilled in the art may understand that the RDL may further include the second surface (generally, the second surface of the RDL is parallel to the first surface of the RDL), and an electrical interconnection between the metal wiring that is exposed on the second surface of the RDL and the connected PCB may be implemented by using a connector.

Similarly, the substrate may also include a second surface (generally, the second surface of the substrate is parallel to the first surface of the substrate), and an electrical interconnection between the second surface of the substrate and the connected top-layer chip may be implemented by using a weld ball.

It should be noted that the active surface of the target chip is parallel to the back surface of the target chip, the first surface that is of the RDL and is opposite to the active surface of the target chip is parallel to the active surface, and a surface area of the first surface of the RDL is greater than or equal to a surface area of the active surface. The first surface that is of the substrate and is opposite to the back surface of the target chip is parallel to the back surface of the target chip, and a surface area of the first surface of the substrate is greater than or equal to a surface area of the back surface. That is, the target chip is wrapped between the RDL and the substrate, and if the target chip is considered as a two-dimensional plane, for example, denoted as a first plane (that may be corresponding to a YOZ plane in FIG. 2). A projection of the target chip on the first plane falls within a range of a projection of the RDL on the first plane, and the projection of the target chip on the first plane falls within a range of a projection of the substrate on the first plane. That is, the substrate and the RDL are distributed so that the target chip is totally covered regardless of viewing from top to bottom or from bottom to top.

It should be understood that, merely for ease of understanding and description in this embodiment of this application, it is assumed that the first plane is parallel to a horizontal plane, and a first direction is a direction that is vertical to the horizontal plane (that is, a vertical direction). In a chip package technology, different layers (such as the RDL, the target chip, and the substrate described above) may be stacked in the vertical direction by using the horizontal plane as a reference, to obtain the chip package structure (for example, as shown in FIG. 2). However, this shall not constitute any limitation on this application, and a case shall fall within the protection scope of this application as long as contact surfaces between layers are separately parallel to the first plane, and the layers are stacked in the first direction from bottom to top. For ease of understanding, an example in which the first plane is parallel to the horizontal plane, and the first direction is a direction vertical to the horizontal plane is used below for description. For brevity, descriptions of same or similar cases are omitted below.

In this embodiment of this application, the interconnection channel is used to implement an electrical interconnection between layers.

Specifically, the interconnection channel is located around the target chip, one end is connected to the first surface of the substrate, and the other end is connected to the first surface of the RDL. More specifically, pads are respectively prepared on the first surface and the second surface of the substrate, and the one end of the interconnection channel is connected to a pad on the first surface of the substrate. The other end of the interconnection channel is connected to the metal wiring that is exposed on the first surface of the RDL, that is, an interconnection between the interconnection channel and the pin of the target chip is implemented by using the metal wiring.

Further, the interconnection channel is also connected to the substrate, connected, by using a conductive structure in the substrate (that is, a solid black line part shown in FIG. 2 that is vertical to the substrate), to a connector that is connected to the second surface of the substrate, and then connected to the top-layer chip above the substrate (a horizontal solid black line on the second surface of the substrate may be understood as a point of contact between the connector and the second surface of the substrate). That is, an electrical interconnection between the target chip and the top-layer chip is implemented.

Still further, the metal wiring that is exposed on the second surface of the RDL is also connected to the connector, and then connected to the PCB below, to implement an electrical interconnection between the target chip, the top-layer chip, and the PCB.

In this way, the electrical interconnection between the layers is implemented by using the interconnection channel.

Generally, a thickness of the substrate may be 170 µm to 560 µm, and a thickness of the RDL may be 30 µm to 50 µm. Therefore, a thickness of the entire chip package structure can be greatly reduced by replacing the substrate with the RDL. Therefore, in the chip package structure in this embodiment of this application, a lower-layer substrate is replaced with the RDL, and a limitation on the package structure that is caused by a substrate technology is reduced. A total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth is increased. In addition, an upper-layer substrate is still retained in the chip package structure, so that a warping degree of the chip package structure can be well controlled to be within an acceptable range.

Optionally, as shown in FIG. 2, the chip package structure further includes a molding compound (Molding Compound, MC) 32.

The MC is filled between the substrate and the RDL, and surrounds the target chip around the target chip, so that the target chip is isolated from the outside, moisture proof, dustproof, and buffer functions are provided, and relative motion between the target chip and the substrate can be avoided.

The MC may surround a side surface and the back surface of the target chip, or surround a side surface of the target chip, so as to reduce impact of the outside on the target chip. When only the side surface of the target chip is surrounded by the MC, an adhesive material 38 may be coated between the back surface of the target chip and the first surface of the substrate, so that the target chip is fastened on the first surface of the substrate.

As an example instead of a limitation, the adhesive material 38 may include at least one of the following: thermal compression non-conductive paste (Thermal Compression Non-Conductive Paste, TCNCP), a thermal compression non-conductive film (Thermal Compression Non-Conductive Film, TCNCF), a die attach film (Die Attach Film, DAF), or epoxy (Epoxy).

That is, the adhesive material may be any one of the foregoing examples, or any combination of the foregoing examples.

In this embodiment of this application, the adhesive material may be evenly coated on all or a part of the first surface of the MC.

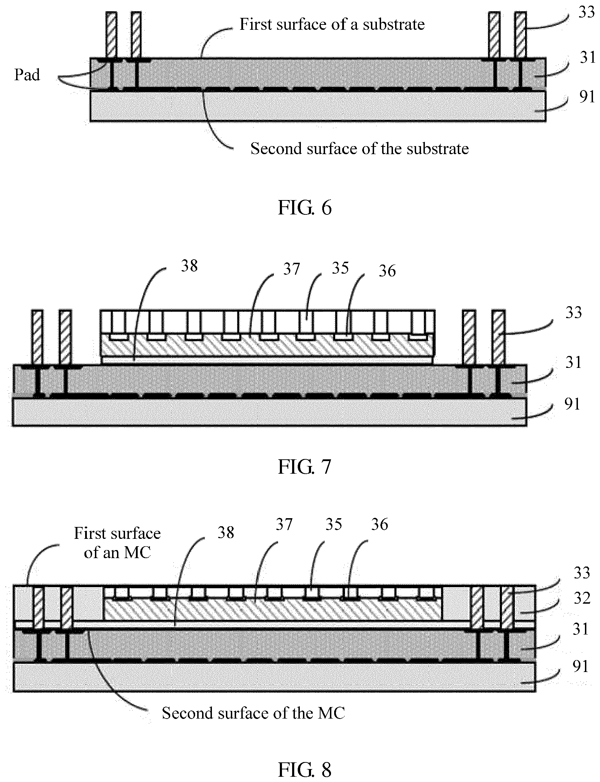

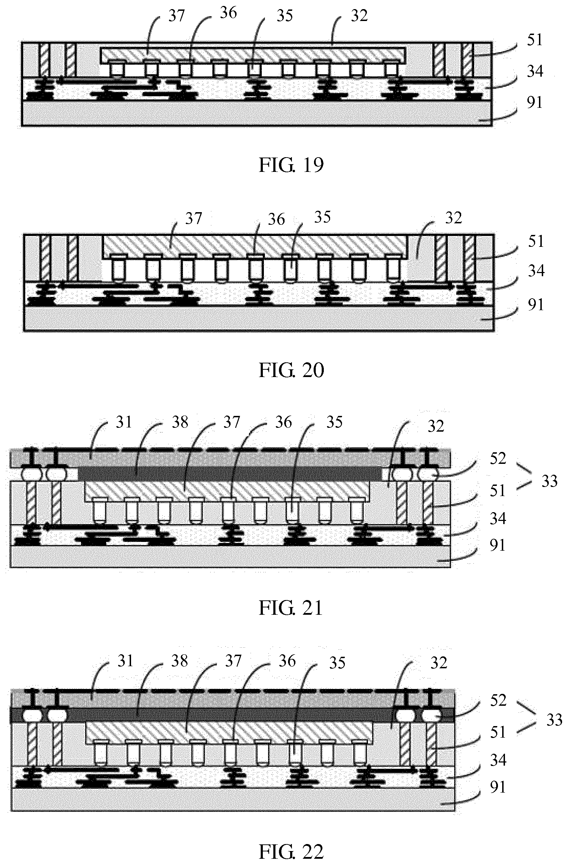

In an embodiment, before the substrate is integrated, the DAF may be first laminated on the back surface of the target chip, and another adhesive material, for example, the epoxy, is coated on a region corresponding to the first surface of the MC (that is, a surface that is opposite to the first surface of the substrate) and a surrounding region of the target chip. When the substrate is being integrated, the adhesive material may be deformed by means of thermal compression to evenly wrap the interconnection channel (for details, refer to FIG. 8 and FIG. 22), so that the back surface of the target chip is protected, and reliability of the interconnection channel is improved.

In another embodiment, when the adhesive material is the TCNCP/TCNCF, when the substrate is being soldered, the adhesive material may be deformed by means of thermal compression to evenly wrap the interconnection channel (for details, refer to FIG. 8 and FIG. 22), so that the back surface of the target chip is protected, and reliability of the interconnection channel is improved. It should be understood that the adhesive material in the examples is merely an example for description, and shall not constitute any limitation on this application, and this application should not be limited thereto. For example, the adhesive material may be another material that can implement a same function.

In this embodiment of this application, the MC is made from a grindable material. For example, the MC may be made from a resin material, and some hard filler particles (for example, silicon dioxide) may be added to the MC to improve performance of the MC. That is, a thickness of the MC may be reduced by means of grinding.

In this embodiment of this application, the MC may be ground according to a preset thickness of the chip package structure.

That is, a thickness of the chip package structure may be determined according to a thickness that is required for the chip package structure by a device to which the chip package structure is applied, so that the thickness of the chip package structure is further reduced by grinding the MC.

In this embodiment of this application, the interconnection channel extends through the MC, the two ends of the interconnection channel are respectively exposed on two surfaces of the MC that are opposite to the substrate and the RDL. Specifically, in a filling process, a filling height of the MC in the first direction may be higher than a highest surface point of the target chip, and higher than the interconnection channel (it may be understood that a height of the interconnection channel in the first direction is greater than or equal to a height of the target chip in the first direction).

In a chip package process, regardless of whether the target chip is inverted (details are described below with reference to a chip packaging method), the filling height of the MC may be higher than the highest surface point of the target chip during filling of the MC. The highest surface point of the target chip may be understood as a point in a relatively high position in the active surface and the back surface of the target chip by using the first plane as a reference. Generally, when the chip is delivered, the surface is processed and is generally relatively flat. Therefore, the highest surface point of the target chip may be understood as a surface in a relatively high position in an upper surface and a lower surface of the target chip during filling of the MC.

In addition, a person skilled in the art may understand that the chip may be inverted in the chip package process due to different chip packaging methods. The highest surface point of the target chip during filling of the MA described herein is a point that is in a relatively high position in the active surface or the back surface of the target chip within this special time period of filling the MC, but this does not mean that the point is always the highest surface point of the target chip.

In this embodiment of this application, the thickness of the MC may be adjusted according to the preset thickness of the chip package structure. In a possible implementation, the thickness of the MC may be reduced by means of grinding. Specifically, after the MC is filled, the MC may be ground according to a requirement, so that the interconnection channel is exposed on the surface of the MC, or both the interconnection channel and the back surface of the target chip are exposed on the surface of the MC (corresponding to packaging methods 2 and 3 described below), or both the interconnection channel and the back surface of the target chip are exposed on the surface of the MC (corresponding to the packaging method 1 described below), an exposed surface of the MC is flat, and the total thickness of the chip package structure is reduced.

In this embodiment of this application, the thickness of the MC is approximately 100 µm to 200 µm.

It should be understood that an MC grinding manner shown in this embodiment of this application is merely an example for description, and shall not constitute any limitation on this application. In this embodiment of this application, a hole may be opened for the MC in a laser opening manner to expose the interconnection channel. Alternatively, the MC is first ground according to a requirement, and then a laser opening manner is used to expose the interconnection channel on the MC.

Specifically, if the laser opening manner is used, whether the MC needs to be first ground may be determined according to a case. If the MC covers the back surface of the target chip, the MC may be ground until the back surface of the target chip is exposed, and then a hole is opened for the MC in the laser opening manner. In this case, a first copper pillar or a grinding weld ball of a smaller size may be used for the interconnection channel. For example, a first copper pillar with a smaller height or a grinding weld ball with a smaller diameter is used. This manner can cause less pollution to the target chip in a grinding process.

Optionally, the interconnection channel extends through the MC in the first direction, and the first direction is basically vertical to the first surface of the RDL.

The first plane is used as a reference, and the interconnection channel may extend through the MC by means of being vertical to the first plane, that is, may be corresponding to an OX direction (for ease of description, denoted as the first direction) in FIG. 2.

In this embodiment of this application, the interconnection channel that vertically extends through the MC may be referred to as a vertical interconnection channel or a vertical interconnect system (Vertical Interconnects System, VIS).

Herein, that the first direction is basically vertical to the first surface of the RDL may mean that an included angle between the first direction and the first surface of the RDL is approximately 90 degrees. That is, the included angle between the first direction and the first surface of the RDL may have a specific error range during preparation, but this may be ignored or is allowed.

As an example instead of a limitation, the interconnection channel may include a first copper pillar; or the interconnection channel may include a first copper pillar and a first connector, or a grinding weld ball and a first connector. In this embodiment of this application, because a new interconnection channel is used as a conductive channel between the substrate and the RDL, the thickness of the chip package structure can be further reduced.

Specifically, if the interconnection channel is the first copper pillar, the first copper pillar may be pre-electroplated on the first surface of the substrate. In an embodiment, a diameter of the first copper pillar is greater than or equal to 100 micrometers µm, and a height is greater than or equal to 100 µm. In this case, a minimum thickness of the chip package structure may be 300 (170+30+100=300) µm to 400 (170+30+200=400) µm.

If the interconnection channel is the first copper pillar and the first connector, one end of the first copper pillar may be connected to the metal wiring that is exposed on the first surface of the RDL, and the other end may be connected to the first surface of the substrate by using the first connector. The first connector may be either pre-solder paste or a weld ball. In an embodiment, a diameter d₁ of the weld ball meets 40 µm<d₁≤100 µm, and the weld ball may be, for example, a solder ball (solder ball), a solder bump (solder bump), a copper core solder ball (Cu-core solder ball, CCSB), or a controlled collapse chip connection (Controlled Collapse Chip Connection, C4). A specific material or form of the weld ball is not limited in this application. A diameter of the first copper pillar is greater than or equal to 100 micrometers µm, and a height is greater than or equal to 100 µm. A height of the pre-solder paste is approximately 20 µm. The heights of the first connector and the first copper pillar may be selected according to an actual requirement. It may be learned, by means of calculation, that a minimum thickness of the chip package structure may be 320 µm.

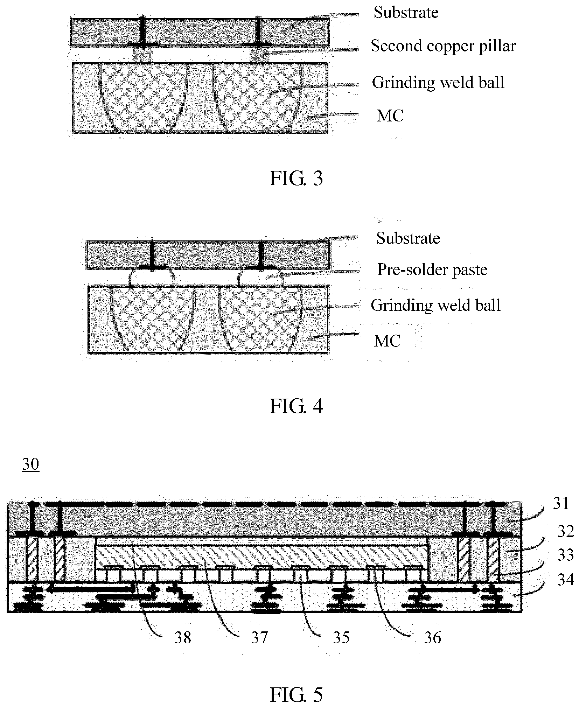

If the interconnection channel is the grinding weld ball and the first connector (as shown in FIG. 3 and FIG. 4), one end of the grinding weld ball may be connected to the metal wiring that is exposed on the first surface of the RDL, and the other end may be connected to the first surface of the substrate by using the first connector. In an embodiment, the grinding weld ball may be a weld ball whose diameter is 200 µm, and a hemisphere whose height is only 100 µm may be obtained by means of grinding. The first connector may be any one of the following: a second copper pillar, pre-solder paste, or a weld ball. A diameter of the second copper pillar may be less than 100 µm, and a height may be less than 100 µm. Typically, the diameter of the second copper pillar may be 40 µm, and the height may be 5 µm to 50 µm. A diameter of the weld ball may be greater than or equal to 40 µm, and a height of the pre-solder paste may be 20 µm. It may be learned, by means of calculation, that a minimum thickness of the chip package structure may be 305 µm (the first connector is a second copper pillar whose height is 5 µm) or 320 µm (the first connector is pre-solder paste whose height is 20 µm).

When the grinding weld ball is used as the interconnection channel, compared with a compression weld ball in the prior art, the grinding weld ball does not occupy a larger package area while the thickness is reduced. It may be understood that in the prior at, a thickness of the compression weld ball is reduced by means of thermal compression. Due to thermal compression, a size of the weld ball decreases in a longitudinal direction (that is, the first direction), and a size of the weld ball increases in a horizontal direction (that is, a direction that is vertical to the first direction). However, in this embodiment of this application, the weld ball is ground by using a grinding technology, so that a longitudinal size is reduced without affecting a horizontal size. Therefore, compared with the compression weld ball in the prior art, the grinding weld ball has a larger advantage.

It should be understood that the specific materials and forms of the interconnection channel that are described above are merely examples for description, and shall not constitute any limitation on this application. The interconnection channel may be another equivalent structure that has an electrical interconnection function. For example, the vertical interconnection channel may be a printed circuit board bar (PCB Bar) or a through silicon via (Through Silicon Via, TSV) module (Module). The PCB bar is a module that is prepared by using a PCB technology and that has a PCB through hole. TSV modules are small modules that have TSVs and that are obtained after the TSVs are prepared on a wafer by using a TSV technology and then the wafer is cut. Each PCB bar or each TSV module includes one or more vertical interconnection channels. The PCB bar or the TSV module and the target chip may be integrated and packaged together by using the fan out wafer level package technology and processes such as wafer reconstruction and wafer wiring, or multiple PCB bars or TSV modules may be integrated in an interconnection region between a periphery and the target chip.

Therefore, in the chip package structure in this embodiment of this application, a lower-layer substrate is replaced with the RDL, and compared with the prior art, a limitation on the package structure that is caused by a substrate processing technology is reduced, so that the total thickness is reduced, and the chip package structure can be more widely applied to a terminal device that has a relatively high thickness requirement. In addition, pin density is increased. Further, the vertical interconnection channel is used in this embodiment of this application, so that a minimum distance between interconnection channels can be prevented from being limited, interconnection channel density can be increased, and bandwidth of the top-layer chip is further increased. Still further, an upper-layer substrate is still retained in the chip package structure, so that a warping degree of the chip package structure can be well controlled to be within an acceptable range.

It should be understood that the chip package structure in the embodiments of this application is described above in detail with reference to FIG. 2. However, the structure shown in FIG. 2 is merely a possible implementation of the embodiments of this application, and shall not constitute any limitation on this application. For example, two RDLs may be used to replace two substrate layers in the chip package structure, so that a total thickness of the structure can be reduced by using the RDLs, and pin density is increased. Alternatively, an RDL may be used to replace an upper-layer substrate in the chip package structure, and a lower-layer substrate is retained, so that a total thickness of the structure can also be reduced.

For ease of understanding, the chip package structure in the embodiments of this application is described below in detail with reference to chip packaging methods (including a packaging method 1, a packaging method 2, and a packaging method 3). However, it should be understood that the chip packaging methods shown below are merely possible implementations for implementing the chip package structure in the embodiments of this application, and shall not constitute any limitation on this application. The embodiments of this application should not be limited thereto.

### Packaging method 1:

FIG. 5 is a schematic structural diagram of a chip package structure 30 according to an embodiment of this application. As shown in FIG. 5, the chip package structure 30 includes a substrate 31, an MC 32, a vertical interconnection channel 33, an RDL 34, a target chip 37, and an adhesive material 38. A pad 36 of the target chip 37 is connected, by using a second connector 35, to a metal wiring that is exposed on a first surface of the RDL 34 (or more specifically, a dielectric layer). Specifically, the pad 36 of the target chip 37 may be connected, by using the second connector 35, to the metal wiring that is exposed on the first surface of the RDL 34, to implement an electrical interconnection between the RDL and a pin of the target chip.

The chip package structure 30 is described below in detail with reference to FIG. 6 to FIG. 12. FIG. 6 to FIG. 12 are schematic diagrams of packaging the chip package structure 30 in an embodiment of this application by using a chip packaging method.

First, step 1a is performed: As shown in FIG. 6, mount the substrate 31 on a carrier (carrier) 91. In an actual execution process, multiple substrates may be mounted on the carrier at a preset spacing.

The carrier may be glass, ceramic, metal, or another material that has a similar function and that is compatible with a wafer-level package technology.

Optionally, a structural film or a functional film, for example, an adhesive layer (adhesive layer) film, a sacrificial layer (sacrificial layer) film, a buffer layer (buffer layer) film, or a dielectric layer (dielectric layer) film, may be selectively coated on the carrier. More specifically, the adhesive layer film and the sacrificial layer film each may be an ultraviolet (Ultra-Violet, UV) curing adhesive, a light-to-heat conversion (light-to-heat conversion, LTHC) film, or a material that has a similar function and that is compatible with the wafer-level package technology. The dielectric layer film may be polyimide (polyimide, PI), polybenzoxazole (PolyBenzoxazole, PBO), benzocyclobutene (BenzoCycloButene, BCB), an ajinomoto buildup film (Ajinomoto Buildup Film, ABF) that is supplied by the Ajinomoto company in Japan, a solder resist film (Solder Resist film, SR), or another material that has a similar function and that is compatible with the wafer-level package technology.

A person skilled in the art may understand that the carrier and the substrate have different functions, the carrier may be understood as a carrier that has a support function in a chip package process, does not belong to the chip package structure, and is merely used in the package process, and the carrier may be removed after a corresponding step is completed. The substrate may be understood as a part of the chip package structure, and a circuit used for an electrical interconnection is distributed in the substrate. For brevity, descriptions of same or similar parts are omitted below.

In this embodiment of this application, the vertical interconnection channel 33 is implanted in the substrate 31 in advance. Specifically, the vertical interconnection channel may be preconnected to a pad on a first surface of the substrate 31 in an electroplating manner. An organic substrate or a silicon substrate may be selected as the substrate (or referred to as an interposer) according to a signal quantity and an application requirement. The interconnection channel may be a first copper pillar. It should be understood that using the copper pillar as the vertical interconnection channel is merely a possible implementation, and the vertical interconnection channel may be aluminum or another structure that has an equivalent electrical interconnection function.

It should be noted that pads may be disposed on the first surface and a second surface of the substrate 31, the substrate may be connected to the carrier by using a pad on the second surface, and may be connected to the vertical interconnection channel by using the pad on the first surface. The pads may be disposed on the first surface and the second surface of the substrate in a surrounding array form or a plane array form.

Then, step 1b is performed: As shown in FIG. 7 and FIG. 8, coat the adhesive material 38 on a first surface of the substrate 31, and laminate the target chip 37 on the first surface of the substrate 31.

The adhesive material is coated, so that the target chip can be fastened on the substrate, and a stress buffer function can also be provided.

FIG. 7 and FIG. 8 are schematic diagrams of cases in which different adhesive materials are used. The adhesive material 38 shown in FIG. 7 may be epoxy, a DAF adhesive, PI, or the like. That is, before the substrate 31 is laminated, the adhesive material is coated on a back surface of the target chip.

The adhesive material shown in FIG. 8 may be TCNCP/a TCNCF. That is, before the substrate 31 is laminated, the adhesive material 38 may be coated on the first surface of the substrate 31 or the surface of an MD. When the substrate 31 is being soldered, the TCNCP/TCNCF may protect the back surface of the chip and wrap a connector 33 (as shown in FIG. 8) by means of thermal compression, so as to improve reliability of the connector 33.

It can be learned from the figure that the target chip 33 is totally laminated on the substrate 31. In other words, a projection of the target chip on a first plane falls within a range of a projection of the substrate on the first plane.

In this embodiment of this application, an active surface of the target chip 37 includes multiple pads 36, and the pads 36 may be evenly or unevenly distributed on the active surface of the target chip. The pad may be understood as a pin of the target chip to implement an electrical interconnection between the target chip and the outside.

The second connector 35 may be soldered onto the pad 36, and the second connector 35 is used for connecting the pad 36 to the metal wiring in the RDL 34. The second connector may be a C4, a third copper pillar (Cu pillar), a copper post (Cu post), or another structure that has an equivalent electrical interconnection function. The second connector may be prepared by means of ball attachment, electroplating, printing, or the like.

It should be noted that a size (including a diameter and a height) of the third copper pillar described herein may fall within a same range as the size of the second copper pillar mentioned above. However, this shall not constitute a limitation, that is, the size of the second copper pillar may be the same as or different from the size of the second copper pillar.

Optionally, a buffer material may be filled between second connectors.

Specifically, the buffer material may be an underfill (Under Fill, UF), or may be a dielectric layer material that has a buffer effect. When the buffer material is a dielectric layer material, for selection of the dielectric layer material, refer to a selection range that is described above and that is of the dielectric layer film coated on the carrier.

It should be noted that one or more target chips may be integrated in one package body. In an actual execution process, one or more target chips (or original wafers) may be laminated on the first surface of the substrate. When there are multiple target chips, the multiple chips may be chips in different sizes and of different types that are prepared by using different technologies. A specific size of the chip may be determined according to a product requirement and a technological process, and the chip is ground for thickness reduction according to a requirement. Therefore, a type, a size, and a technology of the target chip are not particularly limited in this application.

It should be further noted that, when there is one target chip, the vertical interconnection channel may be distributed in the MC, and located at a periphery of the target chip; when there are multiple target chips, the vertical interconnection channel may be distributed in the MC, and located in a region between neighboring target chips or a peripheral region of the target chip.

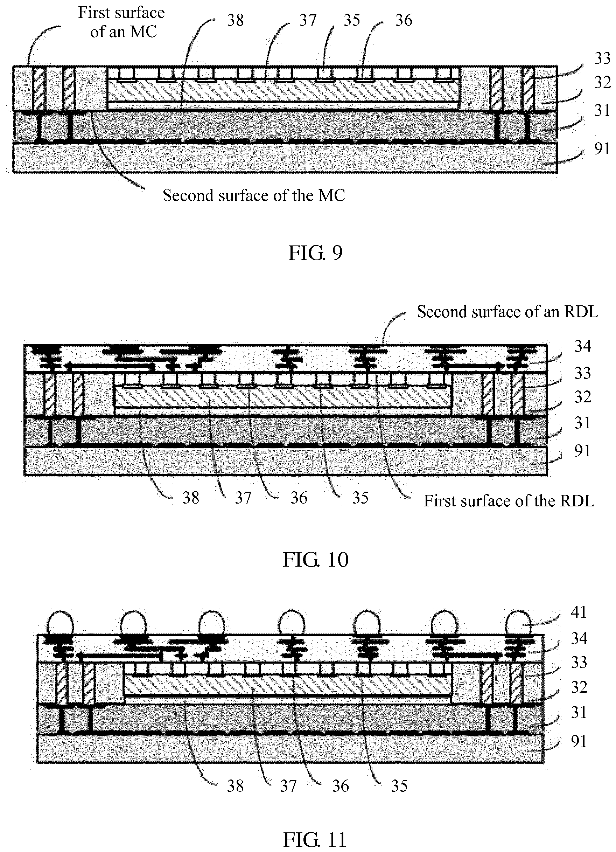

Then, step 1c is performed: As shown in FIG. 9, fill the MC 32, and grind a first surface of the MC 32.

The MC 32 is filled on the first surface of the substrate 31, and surrounds a side surface of the target chip 37, so that both the back surface and the side surface of the target chip are isolated from the outside, and the active surface is laminated on the RDL by performing step 1d described below.

A filling height of the MC is at least higher than the active surface of the target chip (that is, a surface that is located above and that is shown in FIG. 8). Then, the MC may be ground according to a requirement to reduce a thickness of the MC, so that the second connector 35 and the vertical interconnection channel 33 can be exposed from the MC.

The first surface of the MC can be flat by grinding the MC, and a thickness of the chip package structure can be further reduced.

In this embodiment of this application, the MC may be ground according to a preset thickness of the chip package structure.

That is, the thickness of the chip package structure may be determined according to a thickness that is required for the chip package structure by a device to which the chip package structure is applied, so that the thickness of the chip package structure is further reduced by grinding the MC.

In this embodiment of this application, the second connector 35 not only plays a role in connecting the pad of the target chip to the RDL, but also can protect the target chip and reduce stress damage to the target chip in an MC grinding process.

Optionally, a buffer material (for example, UF) may be filled between second connectors 35, so that structure strength and reliability are improved.

Then, step 1d is performed: As shown in FIG. 10, prepare the RDL 34.

A dielectric layer is coated on the surface of the structure obtained in step 1c, and a metal wiring is prepared inside or on the surface of the dielectric layer. For selection of a dielectric layer material, refer to a selection range of the dielectric layer film coated on the carrier described above. The RDL may be prepared by using technologies such as coating, exposure, developing, curing, sputtering, electroplating, and etching. A material of the metal wiring may be a conductive material such as copper or aluminum. The RDL may be one or more wiring layers.

It can be learned from the figure that the RDL 34 covers the target chip 33 and the MC 32 around the target chip 33. In other words, the projection of the target chip on the first plane falls within a range of a projection of the RDL on the first plane.

In this embodiment of this application, a fan out technology is used, so that a pin of the target chip can be wired, in a fan out manner, to the target chip and a periphery region of the target chip to connect to the metal wiring. In addition, for a structure with multiple target chips, the chips may be interconnected by means of fan out metal wiring, and an electrical interconnection between the RDL and the pin of the chip may be implemented by using the metal wiring in the RDL.

Then, step 1e is performed: As shown in FIG. 11, prepare a fourth connector 41 on the surface of the RDL 34.

The chip package structure is used to be installed on a PCB, and therefore, the fourth connector may be prepared on a lower surface of the RDL, so as to connect to the PCB. Specifically, the fourth connector may be a solder ball (solder ball), a CCSB, or an equivalent structure that has a similar electrical connection function, and may be prepared by means of electroplating, printing, ball attachment, or the like.

Optionally, before the fourth connector is prepared, an under bump metallization (under bump metallization, UBM) structure may be selectively prepared, according to an actual requirement, in a region that is in contact with an organic dielectric layer and that is under the fourth connector, so as to improve bonding strength and improve mechanical reliability. A material, a structure, and a technology of the UBM are not limited in this application.

The structure shown in FIG. 11 that is obtained by performing step 1a to step 1e may be referred to as a reconstructed wafer.

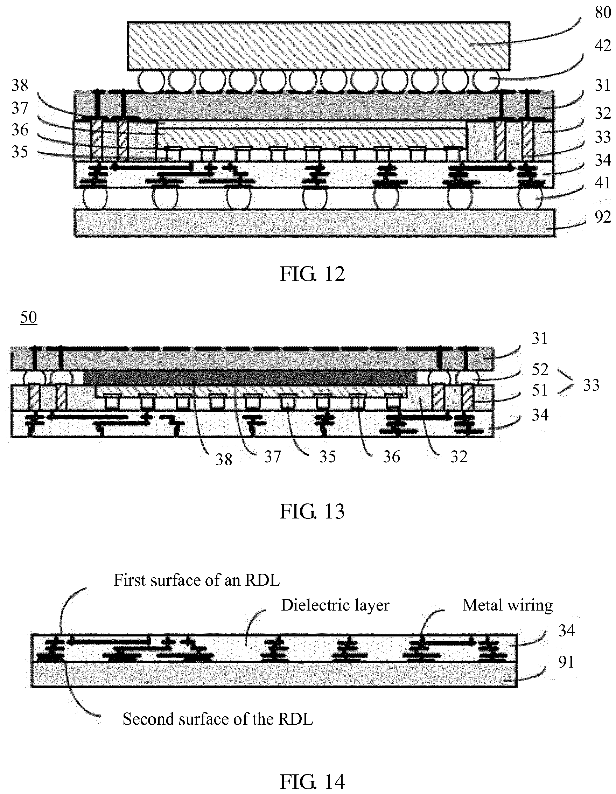

Finally, step If is performed: As shown in FIG. 12, connect a top-layer chip 80 to a second surface of the substrate 31 by using a third connector 42.

In this embodiment of this application, a technology for connecting the top-layer chip may be a surface mount technology (Surface Mount Technology, SMT) (Method 1), or may be a prestack (pre stack) technology (Method 2).

In Method 1, the reconstructed wafer (as shown in FIG. 11) obtained in step 1e may be diced into a single package particle. When the package particle is being soldered onto the PCB, the SMT technology is used, the package particle is laminated on the PCB, and then, the top-layer chip is laminated on a substrate of the package particle in a manner, for example, by using solder paste. Finally, the top-layer chip and the reconstructed wafer are integrated on the PCB by means of reflow.

In Method 2, before the third connector 42 is prepared on the second surface of the substrate 31, the reconstructed wafer (as shown in FIG. 11) obtained in step 1e may be turned over in a vertical direction, to laminate another surface of the reconstructed wafer on a carrier 92, and the carrier 91 may be removed. For a film material that is selected for laminating the reconstructed wafer on the carrier 92, refer to related descriptions in step 1a.

It should be understood that the carrier 92 shown in FIG. 12 and the carrier 91 shown in FIG. 6 to FIG. 11 are different carriers, or are not a same carrier. That is, two carriers are used in this embodiment of this application.

Then, the top-layer chip 80 is connected to the second surface of the substrate 31 by using the third connector 42. Generally, the third connector 42 is predisposed on a top-layer chip 50. For a top-layer chip 50 on which the connector 42 is not predisposed, the third connector 42 may be first prepared on the second surface of the substrate 31, and then, is soldered onto the top-layer chip 50. In this case, the third connector 42 may be interconnected to a pad on the second surface of the substrate, and an interconnection manner may be mass reflow (Mass Reflow), thermo compression bonding (Thermo Compression Bonding), or another equivalent soldering manner.

Finally, the carrier 92 is removed, and the obtained chip package structure is diced to obtain a single package particle. The diced single package particle may be laminated on the PCB by using the SMT, and soldering is implemented by means of reflow.

Optionally, a buffer material may be filled between the PCB and the RDL to improve structure reliability.

Therefore, in the chip package structure in this embodiment of this application, a lower-layer substrate is replaced with the RDL, and a limitation on the package structure that is caused by a substrate technology is reduced. The total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth of a top-layer chip is increased. In addition, the thickness can be further reduced by replacing a thermal compression weld ball with the vertical interconnection channel to implement an electrical interconnection and by using an MC grinding method. In addition, an upper-layer substrate is still retained in the chip package structure, so that a warping degree of the chip package structure can be well controlled to be within an acceptable range.

### Packaging method 2:

FIG. 13 is a schematic structural diagram of a chip package structure 60 according to another embodiment of this application. It should be noted that, for ease of understanding, in the embodiment shown below, for structures shown in different embodiments, a same reference numeral is still used for a same structure, and for brevity, a detailed description of the same structure is omitted.

As shown in FIG. 13, the chip package structure 50 includes a substrate 31, an MC 32, a vertical interconnection channel 33 (including a first copper pillar (or a grinding weld ball) 51 and a first connector 52), an RDL 34, and a target chip 37. A pad 36 of the target chip 37 is connected to a metal wiring that is exposed on a first surface of the RDL 34 by using a second connector 35. Specifically, the pad 36 of the target chip 37 may be connected, by means of soldering by using the connector 35, to the metal wiring that is exposed on the first surface of the RDL 34, to implement an electrical interconnection between the RDL and a pin of the target chip. Optionally, an adhesive material 38, for example, a DAF adhesive or PI, is coated on the target chip and a first surface of the substrate 31. The adhesive material also has a stress buffer function.

The chip package structure 50 differs from the chip package structure 30 shown in FIG. 5 in that the vertical interconnection channel 33 is connected to the substrate 31 by using the first copper pillar (or the grinding weld ball) 51 and the first connector 52, and this is caused by a different package technology of the chip package structure 50.

The chip package structure 50 is described below in detail with reference to FIG. 14 to FIG. 25. FIG. 14 to FIG. 23 are schematic diagrams of packaging the chip package structure 50 in another embodiment of this application by using another chip packaging method.

First, step 2a is performed: As shown in FIG. 14, mount the RDL on a carrier 91.

Specifically, a film material is selectively coated on an upper surface of the carrier 91. For example, the film material may be an adhesive layer film, a sacrificial layer film, or a buffer layer film. Then, one or more RDLs 34 are prepared on the film. Main steps of preparing the RDL include steps such as seed layer sputtering, dielectric layer coating, photolithography, developing, high temperature curing, electroplating, and seed layer removal. UBM may be selectively prepared on the first surface of the RDL. For material selection and preparation methods of the carrier 91, and the film material, the dielectric layer, and the metal wiring on the upper surface of the carrier, refer to the packaging method 1.

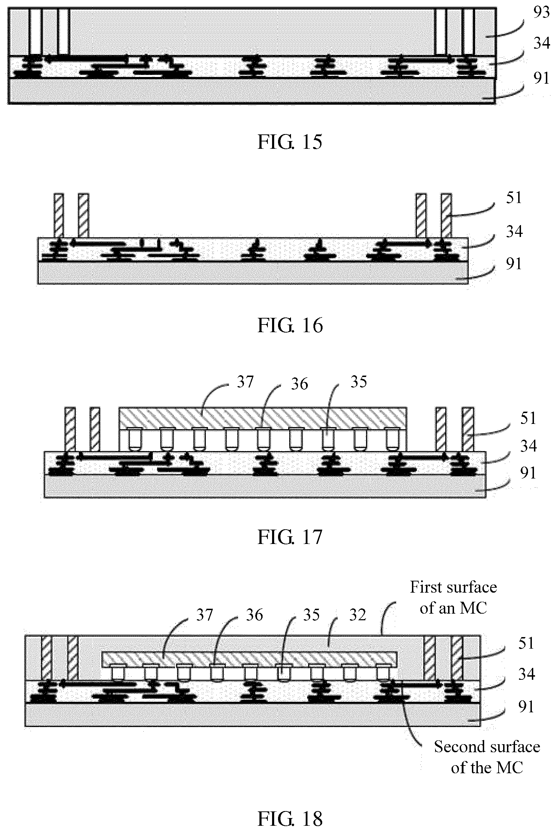

Then, step 2b is performed: As shown in FIG. 15 and FIG. 16, prepare the vertical interconnection channel 33 on a first surface of the RDL 34.

In this embodiment of this application, the vertical interconnection channel 33 may include the first copper pillar (or the grinding weld ball) 51 and the first connector 52. In this step, the first copper pillar (or the grinding weld ball) 51 is first prepared.

The vertical interconnection channel may be prepared by using a technology method such as seed layer sputtering, dry film lamination (dry film lamination) photolithography, developing, curing, electroplating, adhesive removal, seed layer removal, and plastic packaging. That is, the vertical interconnection channel may be electroplated on a position of the metal wiring that is exposed on the first surface of the RDL. A structure and a technology of the vertical interconnection channel are not limited in this embodiment of this application. For example, for the vertical interconnection channel, a vertical interconnection through molding via (Through Molding Via, TMV) is prepared in a molding compound by using a method such as laser drilling or deep reactive ion etching (Deep Reactive Ion Etching, DRIE), and then, the through via is filled with a conductive material to achieve the vertical interconnection channel. The conductive material in the through via may be metal such as copper, aluminum, or stannum, or a conductive adhesive, and a filling manner may be a manner such as electroplating, electroless plating, or adhesive dispensing.

Then, step 2c is performed: As shown in FIG. 17, fasten the target chip 37 on the RDL 34.

Before the target chip 37 is fastened, the second connector 35 may be first prepared on the pad 36 of the target chip 37, then, the target chip 37 with the second connector 35 is fastened on the first surface of the RDL 34, and an interconnection between the second connector 35 and the metal wiring in the RDL 34 is implemented by means of reflow. Optionally, a buffer material (such as UnderFill) or a film material similar to the dielectric layer may be coated between second connectors 35.

For material selection and preparation methods of the target chip, the second connector, and the buffer material, refer to the embodiments described above. It should be noted that if a second copper pillar is selected as the second connector, the top of the second copper pillar needs to include a material that is prone to solder, for example, a solder tip/cap (solder tip/cap), to improve reliability of interconnection between the second connector and the RDL. Optionally, nickel (Ni), titanium (Ti), or another isolation-layer metal may be added on the top of the copper pillar to isolate Cu from stannum (Sn).

Then, step 2d is performed: As shown in FIG. 18 to FIG. 20, fill the MC 32, and grind an upper surface of the MC 32.

Specifically, for a specific method for filling the MC 32, refer to the packaging method 1. A filling height of the MC is higher than a highest surface point of the target chip (that is, a surface that is located above and that is shown in FIG. 18) during filling of the MC. The filling height of the MC may also be reduced by means of grinding. For a grinding thickness of the MC, only the first copper pillar (or the grinding weld ball) 51 may be exposed on a first surface of the MC 32 by means of grinding according to a requirement (as shown in FIG. 19), or an exposed die (Exposed Die) may be made based on a product thickness requirement or a heat dissipation requirement, that is, a first surface of the MC is ground until a back surface of the target chip is exposed on the first surface of the MC (as shown in FIG. 20), or the MC and a back surface of the target chip are further ground to reduce thicknesses of both the MC and the target chip.

The structure obtained in the foregoing step may be referred to as a reconstructed wafer.

Then, step 2e is performed: As shown in FIG. 21, laminate the substrate 31.

Specifically, before the substrate 31 is laminated, a stress buffer layer 38 (for example, a DAS or PI) may be coated on the first surface of the substrate 31, then, the substrate 31 is soldered, by using the first connector 52, onto an upper surface (that is, a position of the back surface of the target chip) of the structure shown in FIG. 19 or FIG. 20, and the first connector 52 is interconnected to the first copper pillar (or the grinding weld ball) 51 by using a pad on the first surface of the substrate, to form the vertical interconnection channel 33.

Specifically, when the grinding weld ball is used in a vertical interconnection channel 51, the first connector may be the second copper pillar (as shown in FIG. 3) or pre-solder (pre-solder) paste (as shown in FIG. 4). The first connector may be first prepared on the pad of the first surface of the substrate 31, or first prepared on a surface that is of the vertical interconnection channel and that is in contact with the substrate. The pre-solder paste may be prepared by using a printing technology, and the second copper pillar may be prepared by using an electroplating method. When the first copper pillar is used in the vertical interconnection channel 51, the first connector is pre-solder paste or a weld ball (as shown in FIG. 20). The weld ball may be pre-soldered onto a pad of a lower surface of the substrate, or pre-soldered onto the second copper pillar. The weld ball may be a solder ball (Solder Ball), a solder bump (Solder Bump), a CCSB, a C4, or another structure that has an equivalent electrical interconnection function.

An order of soldering the substrate may be correspondingly adjusted according to different manners in which the first connector is connected to the first surface of the substrate. If the first connector is preconnected to the first surface of the substrate, the first connector may be directly soldered onto the reconstructed wafer. If the first connector is preconnected to the vertical interconnection channel (or is pre-prepared on the reconstructed wafer), the first connector may be soldered onto the pad of the first surface of the substrate.

Optionally, a stress buffer layer may be filled between the substrate and the MC to improve structure reliability.

FIG. 21 and FIG. 22 are schematic diagrams of cases in which different adhesive materials are used. FIG. 21 is a schematic diagram of a case in which the interconnection channel is not wrapped by the adhesive material. The adhesive material 38 shown in FIG. 21 may be one or more of epoxy, a DAF adhesive, PI, or the like. That is, before the substrate 31 is laminated, the adhesive material is coated on the back surface of the target chip.

FIG. 22 is a schematic diagram of a case in which the interconnection channel is wrapped by the adhesive material. The adhesive material may be one or more of epoxy, a DAF adhesive, PI, TCNCP, a TCNCF, or the like.

In an embodiment, the DAF may be first laminated on the back surface of the target chip 37, and another adhesive material, for example, the epoxy, may be coated on a region corresponding to the first surface of the MC 32 and a surrounding region of the target chip 37. In addition, before the substrate 31 is laminated, the first connector 52 may be pre-soldered onto the first surface of the substrate 31. When the substrate 1 is being laminated, an interconnection between the first connector 52 and the interconnection channel 51 may be implemented to complete soldering by means of reflow. In addition, the adhesive material 38 may be deformed by means of thermal compression to evenly wrap the first connector 52 (as shown in FIG. 22), to protect the back surface of the target chip, and improve reliability of the first connector 52.

In another embodiment, before the substrate 31 is laminated, the TCNCP or the TCNCF may be coated on the first surface of the substrate 31 or the surface of an MD. In addition, before the substrate 31 is laminated, the first connector 52 may be pre-soldered onto the first surface of the substrate 31. When the substrate 31 is being soldered, while an interconnection between the first connector 52 and the interconnection channel 51 is implemented by means of thermal compression, the TCNCP/TCNCF is deformed to wrap the first connector 52 (as shown in FIG. 22), to protect the back surface of the target chip, and improve reliability of the first connector 52. Then, step 2f is performed: Prepare a fourth connector 41 on a second surface of the RDL 34, and then connect the fourth connector 41 to a top-layer chip 80; or
step 2g is performed: Connect a top-layer chip 80 to a second surface of the substrate 31 by using a third connector 42, and then, prepare a fourth connector 41 on a second surface of the RDL 34. Step 2f and step 2g may be implemented by using a prestack technology or an SMT.

If the prestack technology is used, the fourth connector 41 may be first prepared on the second surface of the RDL, and then the top-layer chip 80 is installed (Method a). Alternatively, the top-layer chip 80 may be first installed on the second surface of the substrate, and then the fourth connector 41 is prepared on the second surface of the RDL (Method b).

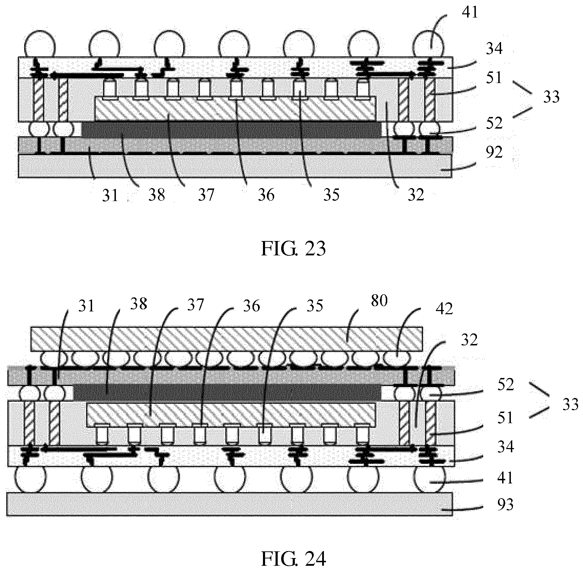

Specifically, in Method a, the structure obtained in step 2e may be first turned over to a carrier 92, so that the second surface of the RDL faces upward, and then the fourth connector 41 is prepared on the second surface of the RDL (as shown in FIG. 23). For a material and a preparation method of the fourth connector, refer to the packaging method 1. Then, the structure is turned over to a carrier 93, so that the second surface of the substrate layer faces upward, and the top-layer chip is installed (as shown in FIG. 24). For a specific process, refer to the packaging method 1.

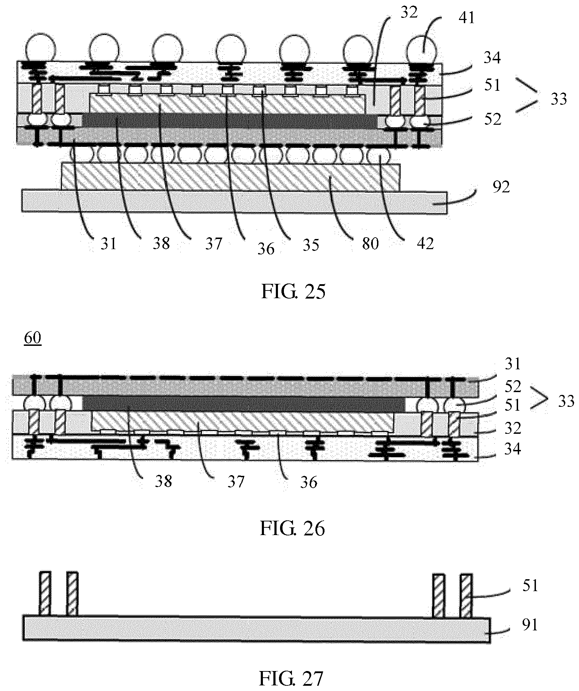

In Method b, the top-layer chip 80 may be first installed on the second surface of the substrate. For a specific process, refer to the packaging method 1. Then, the structure on which the top-layer chip is installed is turned over to a carrier 92, so that the second surface of the RDL faces upward, and the fourth connector 41 is prepared on the second surface of the RDL (as shown in FIG. 25). For a material and a preparation method of the fourth connector, refer to the packaging method 1.

If the SMT is used, the structure obtained in step 2e may be first turned over to a carrier 92, so that the second surface of the RDL 34 faces upward, the fourth connector 41 is prepared (refer to FIG. 23), and then the structure is diced into a single package particle. Finally, when the package particle is being soldered onto a PCB, the diced package particle is fastened on the PCB by using the SMT technology, then the top-layer chip 80 is fastened on the second surface of the substrate 31, and the package particle and the top-layer chip are soldered onto the PCB by means of reflow.

It should be understood that the methods for packaging the top-layer chip in the foregoing example are merely examples for description, and shall not constitute any limitation on this application, and this application does not exclude packaging the top-layer chip by using another existing or future technology.

Therefore, in the chip package structure in this embodiment of this application, a lower-layer substrate is replaced with the RDL, and a limitation on the package structure that is caused by a substrate technology is reduced. A total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth of the top-layer chip is increased. In addition, the thickness can be further reduced by replacing a thermal compression weld ball with the vertical interconnection channel to implement an electrical interconnection and by using a method for grinding the MC and the target chip. In addition, an upper-layer substrate is still retained in the chip package structure, so that a warping degree of the chip package structure can be well controlled to be within an acceptable range.

### Packaging method 3:

FIG. 26 is a schematic structural diagram of a chip package structure 60 according to still another embodiment of this application.

As shown in FIG. 26, the chip package structure 60 includes a substrate 31, an MC 32, a vertical interconnection channel 33 (including a first copper pillar (or a grinding weld ball) 51 and a first connector 52), an RDL 34, and a target chip 37. A pad 36 of the target chip 37 is connected to a metal wiring that is exposed on an upper surface of the RDL 34. The chip package structure 60 differs from the chip package structure 60 shown in FIG. 13 in that the pad 36 of the target chip 37 may be directly connected, by means of soldering, to the metal wiring that is exposed on the upper surface of the RDL 34, to implement an electrical interconnection between the RDL and a pin of the target chip. This is caused by a different package technology of the chip package structure 60.

Optionally, an adhesive material 38, for example, a DAF adhesive or PI, is coated on the target chip and a first surface of the substrate 31. The adhesive material also has a stress buffer function.

The chip package structure 60 is described below in detail with reference to FIG. 27 to FIG. 30. FIG. 27 to FIG. 30 are schematic diagrams of packaging the chip package structure 60 in the still another embodiment of this application by using still another chip packaging method.

First, step 3a is performed: As shown in FIG. 27, prepare the vertical interconnection channel 33.

In this embodiment of this application, the vertical interconnection channel 33 may include the first copper pillar (or the grinding weld ball) 51 and the first connector 52. In this step, the first copper pillar (or the grinding weld ball) 51 is first prepared.

A material selected for the vertical interconnection channel 33 in this embodiment of this application may be the same as that selected for the vertical interconnection channel 33 in the packaging method 2. In this embodiment of this application, the first copper pillar (or the grinding weld ball) 51 may be directly prepared on a carrier 91. Specifically, an adhesive layer, a buffer layer, a seed layer, and the like are first prepared on the carrier 91. Then, the first copper pillar (or the grinding weld ball) 51 is prepared by performing steps such as dry film lamination photolithography, electroplating, adhesive removal, and seed layer removal.

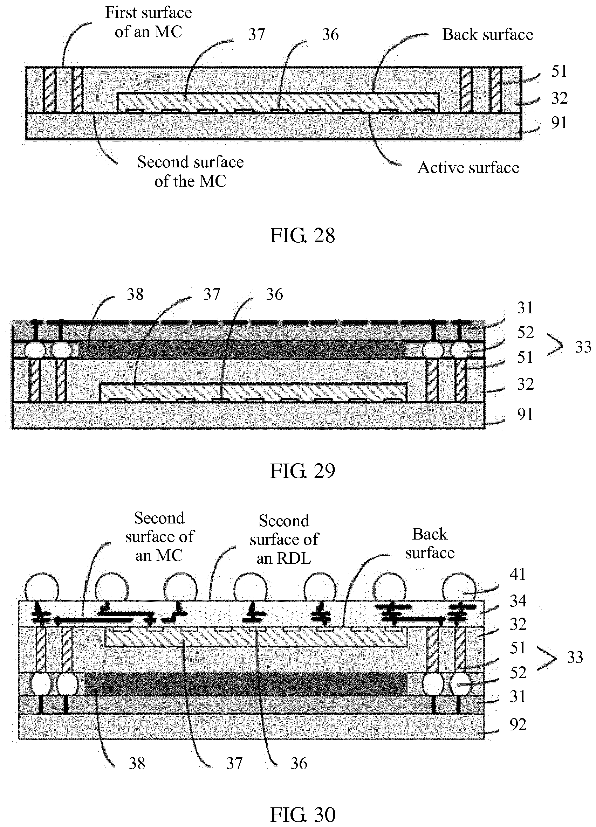

Then, step 3b is performed: As shown in FIG. 28, fasten the target chip 37 on a carrier 91.

In this embodiment of this application, one or more target chips 37 are directly laminated on an upper surface of the carrier 91, and an active surface of the target chip 37 is opposite to the upper surface of the carrier 91, that is, a pin of the target chip is led out by using a pad. Then, the MC 32 is filled to isolate the target chip from the outside, and the MC, or the MC and the target chip are ground according to a requirement, so that a thickness of the chip package structure is reduced, or a back surface of the target chip 37 is exposed (that is, Exposed Die). For a filling height and a package height of the MC, refer to the packaging method 1.

The structure obtained in the foregoing step may be referred to as a reconstructed wafer.

Then, step 3c is performed: As shown in FIG. 29, fasten the substrate 31 on a second surface of the MC 32.

Specifically, the reconstructed wafer may be interconnected to the substrate 31 by using the first connector 52 (that is, a part of the vertical interconnection channel 33). Optionally, a buffer material may be filled between the substrate 31 and the MC 32. For a specific process, refer to the packaging method 2.

Then, step 3d is performed: As shown in FIG. 30, prepare the RDL 34.

Specifically, the structure obtained in step 3c may be first turned over to a carrier 92, and structures such as the adhesive layer and the buffer layer between the carrier 91 and the MC 32 are removed. The back surface of the target chip in the structure obtained after the turnover faces upward, and is level with the second surface of the MC. A dielectric layer is coated on the surface, one or more RDLs are prepared, and then a fourth connector 41 is prepared on a second surface of the RDL.

Finally, step 3e is performed: Fasten a top-layer chip 80.

For details, refer to the packaging method 1 and the packaging method 2.

Therefore, in the chip package structure in this embodiment of this application, a lower-layer substrate is replaced with the RDL, and a limitation on the package structure that is caused by a substrate technology is reduced. The total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth of the top-layer chip is increased. In addition, the thickness can be further reduced by replacing a thermal compression weld ball with the vertical interconnection channel to implement an electrical interconnection and by using an MC grinding method. In addition, an upper-layer substrate is still retained in the chip package structure, so that a warping degree of the chip package structure can be well controlled to be within an acceptable range.

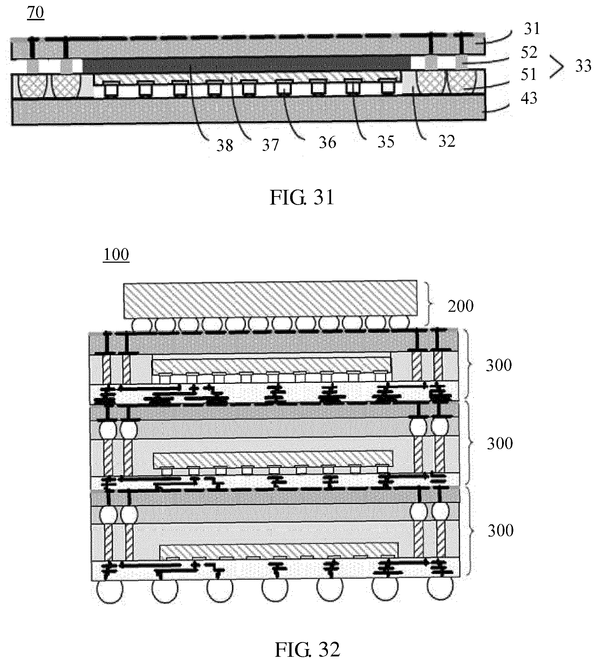

FIG. 31 is a schematic structural diagram of a chip package structure 70 according to yet another embodiment of this application. As shown in FIG. 31, the chip package structure 70 includes a first substrate 31, a second substrate 43, an MC 32, a vertical interconnection channel 33, a target chip 37, and an adhesive material 38. A pad 36 of the target chip 37 is connected to a first surface of the second substrate 43 by means of soldering by using a second connector 35, to implement an electrical interconnection between a pin of the target chip and the second substrate.

The vertical interconnection channel includes a grinding weld ball and a first connector, and the grinding weld ball is connected to the first surface of the second substrate by using the first connector.

The interconnection channel is in contact with an upper surface of the first substrate.

For a specific structure and a packaging method of the chip package structure 70 and a manner of connection between the interconnection channel and the substrate, refer to a substrate-level technology in the prior art. For brevity, details are not described herein.

Therefore, in the chip package structure in this embodiment of this application, the vertical interconnection channel is used to replace a thermal compression weld ball to implement an electrical interconnection, so that a thickness of the chip package structure can be reduced. A quantity of vertical interconnection channels increases while a package area is unchanged, so that bandwidth of a top-layer chip is increased, and warping is well controlled.

The chip package structure in the embodiments of this application is described above in detail with reference to FIG. 2 to FIG. 31. It should be understood that the chip package structure may be separately used, or may be applied to a stacked three-dimensional chip package structure.

FIG. 32 is a schematic structural diagram of a three-dimensional chip package structure 100 according to an embodiment of this application.

As shown in FIG. 32, the three-dimensional chip package structure 100 includes an upper package layer 200 and a lower package layer 300. The upper package layer 200 may include the top-layer chip 80 and the third connector 42 described above, and the lower package layer 300 may include any one or more of the chip package structure 30, 50, 60, or 70 described above, or the lower package layer 200 may include a chip package structure in another form. This is not particularly limited in this application.

Specifically, the three-dimensional chip package structure may include N chip package structures. A first plane is used as a reference. The N chip package structures are vertically stacked from bottom to top, and a target chip of an i^{th} layer of chip package structure is electrically interconnected to a target chip of an (i+1)^{th} layer of chip package structure. N is a total layer quantity of chip package structures included in the three-dimensional chip package structure, N is a natural number greater than 1, i□[1,N-1], and i is a natural number.

Therefore, in the three-dimensional chip package structure in this embodiment of this application, a total thickness of the three-dimensional chip package structure can be reduced by using the chip package structure in the embodiments of this application.

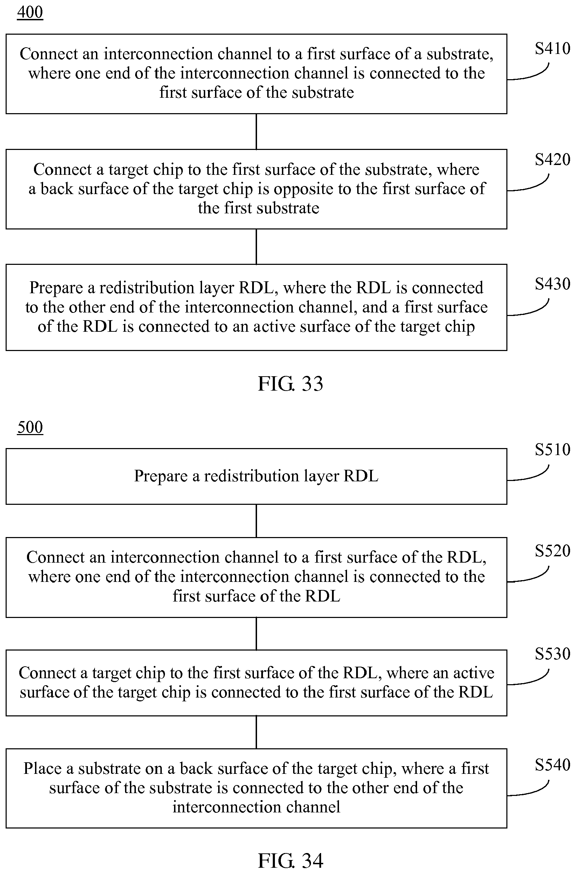

The chip package structure and the three-dimensional chip package structure in the embodiments of this application are described above in detail with reference to FIG. 2 to FIG. 32. The chip packaging method in the embodiments of this application is described below in detail with reference to FIG. 33 to FIG. 35.

FIG. 33 is a schematic flowchart of a chip packaging method 400 according to an embodiment of this application. As shown in FIG. 33, the method 400 includes the following steps:

S410. Connect an interconnection channel to a first surface of a substrate, where one end of the interconnection channel is connected to the first surface of the substrate.

S420. Connect a target chip to the first surface of the substrate, where a back surface of the target chip is opposite to the first surface of the substrate.

S430. Prepare a redistribution layer RDL, where the RDL is connected to the other end of the interconnection channel, and a first surface of the RDL is connected to an active surface of the target chip.

It should be understood that the chip packaging method 400 in this embodiment of this application is described in detail with reference to FIG. 5 to FIG. 12 in the packaging method 1 described above. For brevity, details are not described herein again.

FIG. 34 is a schematic flowchart of a chip packaging method according to another embodiment of this application. As shown in FIG. 34, the method 500 includes the following steps:
S510. Prepare a redistribution layer RDL.
S520. Connect an interconnection channel to a first surface of the RDL, where one end of the interconnection channel is connected to the first surface of the RDL.
S530. Connect a target chip to the first surface of the RDL, where an active surface of the target chip is connected to the first surface of the RDL.
S540. Place a substrate on a back surface of the target chip, where a first surface of the substrate is connected to the other end of the interconnection channel.

It should be understood that the chip packaging method 500 in this embodiment of this application is described in detail with reference to FIG. 13 to FIG. 25 in the packaging method 2 described above. For brevity, details are not described herein again.

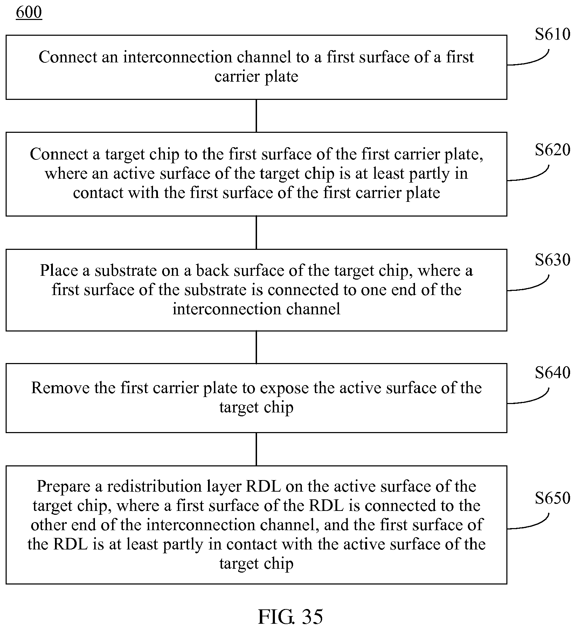

FIG. 35 is a schematic flowchart of a chip packaging method according to still another embodiment of this application. As shown in FIG. 35, the method 600 includes the following steps:
S610. Connect an interconnection channel to a first surface of a first carrier.
S620. Connect a target chip to the first surface of the first carrier, where an active surface of the target chip is at least partly in contact with the first surface of the first carrier.
S630. Place a substrate on a back surface of the target chip, where a first surface of the substrate is connected to one end of the interconnection channel.
S640. Remove the first carrier to expose the active surface of the target chip.
S650. Prepare a redistribution layer RDL on the active surface of the target chip, where a first surface of the RDL is connected to the other end of the interconnection channel, and the first surface of the RDL is at least partly in contact with the active surface of the target chip.

It should be understood that the chip packaging method 600 in this embodiment of this application is described in detail with reference to FIG. 26 to FIG. 30 in the packaging method 2 described above. For brevity, details are not described herein again. The first carrier may be corresponding to the carrier 91 in the packaging method 2, and the first surface of the first carrier may be corresponding to the upper surface of the carrier 91 in the packaging method 2.

Therefore, in the chip packaging method in this embodiment of this application, a lower-layer substrate is replaced with the RDL, and a limitation on a package structure that is caused by a substrate technology is reduced. A total thickness can be reduced, so that the chip package structure can be more widely applied to a terminal device that has a relatively high thickness requirement, and pin density can be increased. In addition, a quantity of vertical interconnection channels increases while a package area is unchanged, so that bandwidth of a top-layer chip is increased. In addition, the thickness can be further reduced by replacing a thermal compression weld ball with the vertical interconnection channel to implement an electrical interconnection and by using an MC grinding method. In addition, an upper-layer substrate is still retained in the chip package structure, so that a warping degree of the chip package structure can be well controlled to be within an acceptable range.

It should be understood that sequence numbers of the foregoing processes do not mean execution sequences in various embodiments of this application. The execution sequences of the processes should be determined according to functions and internal logic of the processes, and should not be construed as any limitation on the implementation processes of the embodiments of this application.

It should be further understood that the described embodiments of the chip packaging method may be executed by using a robot or in a numerical control processing manner, device software or a technology for performing the chip packaging method may perform the chip packaging method by executing computer program code stored in a memory.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a specific working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiment is merely an example. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual requirements to achieve the objectives of the solutions of the embodiments.

In addition, functional units in the embodiments of this application may be integrated into one processing unit, or each of the units may exist alone physically, or two or more units may be integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising:
a redistribution layer RDL;
a target chip, comprising an active surface and a back surface, wherein the active surface of the target chip is connected to a first surface of the RDL;
a substrate, wherein a first surface of the substrate is opposite to the back surface of the target chip; and
an interconnection channel, located around the target chip, wherein one end of the interconnection channel is connected to the first surface of the RDL, and the other end of the interconnection channel is connected to the first surface of the substrate.

2. The chip package structure according to claim 1, wherein the interconnection channel comprises a first copper pillar.

3. The chip package structure according to claim 1, wherein the interconnection channel comprises a grinding weld ball and a first connector, one end of the grinding weld ball is connected to the RDL, and the other end of the grinding weld ball is connected to the first surface of the substrate by using the first connector; and
the grinding weld ball comprises a solder ball, and the first connector comprises any one of the following: a second copper pillar, pre-solder paste, or a weld ball.

4. The chip package structure according to claim 1, wherein the interconnection channel comprises a first copper pillar and a first connector, one end of the first copper pillar is connected to the RDL, and the other end of the first copper pillar is connected to the first surface of the substrate by using the first connector; and
the first connector comprises pre-solder paste or a weld ball.

5. The chip package structure according to any one of claims 1 to 4, wherein the RDL comprises a metal wiring, the active surface of the target chip comprises a pad, and the pad is connected to the metal wiring that is exposed on the first surface of the RDL.

6. The chip package structure according to claim 5, wherein the chip package structure further comprises a second connector, one end of the second connector is connected to the pad, and the other end of the second connector is connected to the metal wiring that is exposed on the first surface of the RDL.

7. The chip package structure according to any one of claims 1 to 6, wherein the chip package structure further comprises a molding compound MC, the MC is filled between the RDL and the substrate, and surrounds the target chip around the target chip, the interconnection channel extends through the MC in a first direction, and the first direction is basically vertical to the first surface of the RDL; wherein
the MC is a grindable material.

8. The chip package structure according to any one of claims 1 to 7, wherein an adhesive material is coated between the first surface of the substrate and the back surface of the target chip, and the adhesive material comprises at least one of the following: thermal compression non-conductive paste, a thermal compression non-conductive film, a die attach film, or epoxy.

9. A three-dimensional chip package structure, comprising at least one layer of the chip package structure according to any one of claims 1 to 8.

10. A chip packaging method, comprising:
connecting an interconnection channel to a first surface of a substrate, wherein one end of the interconnection channel is connected to the first surface of the substrate;
connecting a target chip to the first surface of the substrate, wherein a back surface of the target chip is opposite to the first surface of the substrate; and
preparing a redistribution layer RDL, wherein the RDL is connected to the other end of the interconnection channel, and a first surface of the RDL is connected to an active surface of the target chip.

11. The chip packaging method according to claim 10, wherein the interconnection channel comprises a first copper pillar; and
the connecting an interconnection channel to a first surface of a substrate comprises:
electroplating the first copper pillar on the first surface of the substrate.

12. The chip packaging method according to claim 10 or 11, wherein before the preparing an RDL, the chip packaging method further comprises:
filling the first surface of the substrate with a molding compound MC, so that the MC surrounds the target chip around the target chip; wherein
the active surface of the target chip comprises a pad, the pad is preconnected to one end of a second connector, the other end of the second connector is exposed on a first surface of the MC, the interconnection channel extends through the MC in a first direction, and the first direction is basically vertical to the first surface of the RDL.

13. The chip packaging method according to claim 12, wherein the chip packaging method further comprises:
grinding the first surface of the MC according to a preset thickness of the chip package structure.

14. The chip packaging method according to any one of claims 10 to 13, wherein the RDL comprises a metal wiring, the active surface of the target chip comprises the pad, the pad is preconnected to the one end of the second connector, and the chip packaging method further comprises:
connecting the other end of the second connector to the metal wiring that is exposed on the first surface of the RDL, so that the metal wiring is connected to the active surface of the target chip.

15. A chip packaging method, comprising:
preparing a redistribution layer RDL;
connecting an interconnection channel to a first surface of the RDL, wherein one end of the interconnection channel is connected to the first surface of the RDL;
connecting a target chip to the first surface of the RDL, wherein an active surface of the target chip is connected to the first surface of the RDL; and
placing a substrate on a back surface of the target chip, wherein a first surface of the substrate is connected to the other end of the interconnection channel.

16. The chip packaging method according to claim 15, wherein the interconnection channel comprises a grinding weld ball and a first connector, the grinding weld ball comprises a solder ball, and the first connector comprises a second copper pillar, pre-solder paste, or a weld ball;
the connecting an interconnection channel to a first surface of the RDL comprises:
connecting to the first surface of the RDL by using one end of the grinding weld ball; and
connecting to one end of the first connector by using the other end of the grinding weld ball; and
the chip packaging method further comprises:
connecting, by using the first connector, to the first surface of the substrate by using the other end of the grinding weld ball.

17. The chip packaging method according to claim 15, wherein the interconnection channel comprises a first copper pillar and a first connector, and the first connector comprises pre-solder paste or a weld ball;
the connecting an interconnection channel to a first surface of the RDL comprises:
connecting to the first surface of the RDL by using one end of the first copper pillar; and
connecting to one end of the first connector by using the other end of the first copper pillar; and
the chip packaging method further comprises:
connecting to the first surface of the substrate by using the other end of the first connector.

18. The chip packaging method according to any one of claims 15 to 17, wherein the RDL comprises a metal wiring, the active surface of the target chip comprises a pad, the pad is preconnected to one end of a second connector, and the chip packaging method further comprises:
connecting the other end of the second connector to the metal wiring that is exposed on the first surface of the RDL, so that the metal wiring is connected to the active surface of the target chip.

19. The chip packaging method according to any one of claims 15 to 18, wherein before the placing a substrate on a back surface of the target chip, the chip packaging method further comprises:
filling the first surface of the RDL with a molding compound MC, so that the MC surrounds the target chip around the target chip, wherein the back surface of the target chip is exposed on a second surface of the MC, the interconnection channel extends through the MC in a first direction, and the first direction is basically vertical to the first surface of the RDL.

20. The chip packaging method according to claim 19, wherein the chip packaging method further comprises:
grinding the second surface of the MC according to a preset thickness of the chip package structure.

21. A chip packaging method, comprising:
connecting an interconnection channel to a first surface of a first carrier;
connecting a target chip to the first surface of the first carrier, wherein an active surface of the target chip is at least partly in contact with the first surface of the first carrier;
placing a substrate on a back surface of the target chip, wherein a first surface of the substrate is connected to one end of the interconnection channel, and the back surface of the target chip is a surface that is of the target chip and that is parallel to the active surface;
removing the first carrier to expose the active surface of the target chip; and
preparing a redistribution layer RDL on the active surface of the target chip, wherein a first surface of the RDL is connected to the other end of the interconnection channel, and the first surface of the RDL is at least partly in contact with the active surface of the target chip.

22. The chip packaging method according to claim 21, wherein the interconnection channel comprises a grinding weld ball and a first connector, the grinding weld ball comprises a solder ball, the first connector comprises a second copper pillar, pre-solder paste, or a weld ball, and the chip packaging method further comprises:
connecting to the first surface of the substrate by using one end of the first connector;
connecting to one end of the grinding weld ball by using the other end of the first connector; and
connecting to the first surface of the RDL by using the other end of the grinding weld ball.

23. The chip packaging method according to claim 21, wherein the interconnection channel comprises a first copper pillar and a first connector, the first connector comprises pre-solder paste or a weld ball, and the chip packaging method further comprises:
connecting to the first surface of the substrate by using one end of the first connector;
connecting to one end of the first copper pillar by using the other end of the first connector; and
connecting to the first surface of the RDL by using the other end of the first copper pillar.

24. The chip packaging method according to any one of claims 21 to 23, wherein the RDL comprises a metal wiring, the active surface of the target chip comprises a pad, and the chip packaging method further comprises:
soldering the pad onto the metal wiring that is exposed on the first surface of the RDL, so that the metal wiring is connected to the active surface of the target chip.

25. The chip packaging method according to any one of claims 21 to 24, wherein before the placing a substrate on a back surface of the target chip, the chip packaging method further comprises:
filling the first surface of the carrier with a molding compound MC, so that the MC surrounds the target chip and the back surface of the target chip around the target chip, wherein the interconnection channel extends through the MC in a first direction, and the first direction is vertical to the first surface of the RDL.

26. The chip packaging method according to claim 25, wherein the chip packaging method further comprises:
grinding a first surface of the MC according to a preset thickness of the chip package structure, wherein the first surface of the MC is opposite to the first surface of the substrate.
